# EUROPÄISCHE PATENTSCHRIFT

(11) **EP 1 210 773 B1**
(45) Veröffentlichungstag und Bekanntmachung des Hinweises auf die Patenterteilung: **15.01.2003**
(21) Anmeldenummer: 00958182.8
(22) Anmeldetag: 28.07.2000
(51) Int. Cl.: H03M 1/34

(54) **ANALOG-DIGITAL-WANDLER FÜR EIN SIGNAL IM GIGAHERTZ-BEREICH, MILLIMETERWELLENEMPFÄNGER UND BANDPASSFILTER FÜR MILLIMETERWELLEN**
ANALOG-TO-DIGITAL CONVERTER FOR A SIGNAL IN THE GIGAHERTZ RANGE, MILLIMETRIC WAVE RECEIVERS AND BANDPASS FILTER FOR MILLIMETRIC WAVES
CONVERTISSEUR ANALOGIQUE/NUMERIQUE DESTINE A UN SIGNAL DU DOMAINE DES GIGAHERTZ, RECEPTEUR D'ONDES MILLIMETRIQUES ET FILTRE A BANDE PASSANTE POUR ONDES MILLIMETRIQUES

(30) Priorität: 29.07.1999 DE 19935666
(43) Veröffentlichungstag der Anmeldung: 05.06.2002
(73) Patentinhaber: DaimlerChrysler AG, 70567 Stuttgart (DE)
(72) Erfinder: LUY, Johann-Friedrich, D-89073 Ulm (DE)
(86) Internationale Anmeldenummer: DE0002479
(87) Internationale Veröffentlichungsnummer: WO01010033

(56) Entgegenhaltungen:
- EP-A- 0 452 212
- KATEHI L P B ET AL: "MEMS AND SI-MICROMACHINED COMPONENTS FOR LOW-POWER, HIGH-FREQUENCY COMMUNICATIONS SYSTEMS" IEEE MTT-S INTERNATIONAL MICROWAVE SYMPOSIUM DIGEST,US,NEW YORK, NY: IEEE, 7. Juni 1998 (1998-06-07), Seiten 331-333, XP000822031 ISBN: 0-7803-4472-3
- CHITICA N ET AL: "MONOLITHIC INP-BASED TUNABLE FILTER WITH 10-NM BANDWIDTH FOR OPTICAL DATA INTERCONNECTS IN THE 1500-NM BAND" IEEE PHOTONICS TECHNOLOGY LETTERS,IEEE INC. NEW YORK,US, Bd. 11, Nr. 5, Mai 1999 (1999-05), Seiten 584-586, XP000830421 ISSN: 1041-1135
- PAPAPOLYMEROU J ET AL: "A MICROMACHINED HIGH-Q X-BAND RESONATOR" IEEE MICROWAVE AND GUIDED WAVE LETTERS,US,IEEE INC, NEW YORK, Bd. 7, Nr. 6, 1. Juni 1997 (1997-06-01), Seiten 168-170, XP000690394 ISSN: 1051-8207
- NGUYEN C T -C ET AL: "Tunable, switchable, high-Q VHF microelectromechanical bandpass filters" 1999 IEEE INTERNATIONAL SOLID-STATE CIRCUITS CONFERENCE. DIGEST OF TECHNICAL PAPERS. ISSCC. FIRST EDITION (CAT. NO.99CH36278), 1999 IEEE INTERNATIONAL SOLID-STATE CIRCUITS CONFERENCE. DIGEST OF TECHNICAL PAPERS. ISSCC. FIRST EDITION, SAN FRANCISCO, C, Seiten 78-79, XP002163715 1999, Piscataway, NJ, USA, IEEE, USA ISBN: 0-7803-5126-6
- VU T T ET AL: "GALLIUM ARSENIDE BASED MICRO-ACCELEROMETERS" MIDWEST SYMPOSIUM ON CIRCUITS AND SYSTEMS,US,NEW-YORK, NY: IEEE, 3. August 1997 (1997-08-03), Seiten 1111-1115, XP000789352 ISBN: 0-7803-3695-X

## Beschreibung

Die Erfindung betrifft einen Analog-Digital-Wandler für ein Signal im Gigahertz-Bereich, einen Millimeterwellen-Empfänger und einen Bandpaßfilter für Millimeterwellen.

Es sind Millimeterwellen-Empfänger bekannt, die nach dem Superhet-Empfangsprinzip aufgebaut sind und bei denen über mehrere analoge Mischstufen das Signal im Gigahertz-Bereich in einen Frequenzbereich heruntergemischt wird, der einer digitalen Signalverarbeitung zugänglich ist. Dieser Bereich, der unter wirtschaftlich relevanten Bedingungen einer digitalen Bearbeitung und der insbesondere einer Digital-Analog-Wandlung zugänglich ist, liegt derzeit in der Größenordnung von etwa 10 MHz. Ein typischer Aufbau für einen derartigen Analog-Digital-Wandler zeigt eine Sample and Holdstufe, einen mit der Abtastfrequenz getakteten Schalter, der mit einem Lade-Kondensator C zusammenwirkt, und einen Komparator. Der Analog-Digital-Wandler wandelt das ihm zugeführte analoge Signal in ein digitales Signal.
Weiterhin sind beispielsweise aus dem US-Patent US 5,175, 521 ein mittels Mikromechanik einstellbarer variabler Kondensator bzw. Ringresonator bekannt. Derartige mikromechanische Komponenten werden in Verfahren zur Chipherstellung auf Wafern hergestellt und können mit elektronischen Schaltungen in Form von integrierten Schaltkreisen kombiniert werden.

Aus dem Bereich der planaren Schaltungstechnik sind Arbeiten von Katehi (Katehi LPB et al., *Mems and Si-Micromachined Components for Low-Power*, HF Communications Systems, IEEE MTT-S Digest, 1998 PP. 331-333) und Papaplymerou (Papaplymerou J et al., *A Micromachined High-QX-Band Resonator,* IEEE Microwave and Guided Wave Letters, Vol.7, No.6, 1997 pp 168-170) bekannt, welche sich mit der Gestaltung und Verwendung von dreidimensionalen Millimeterwellen-Filter beschäftigen. Dabei weisen die beschriebenen Millimeterwellen-Filter vertikale für planare integrierte Digitalschaltungen geeignete Resonatorstruktur auf. Zur Herstellung solcher Filter wird auf die Methode des Waferbondings, d.h. des Aufeinanderklebens von einzelnen Wafern, zurückgegriffen. Dieses Verfahren ermöglicht es unter anderem vertikale Strukturen herzustellen, wobei auf einfache Weise zwischen den einzelnen Schichten dieser Strukturen Metallisierungen eingebracht werden können. Die Kopplung zwischen den einzelnen Wavern erfolgt hierbei kapazitiv über Schlitze. In bezug auf die Verwendung eines solchen Filters beschreibt Katehi die Möglichkeit ein solches vertikal, über mehrere Waferebenen realisierte dreidimensionale Millimeterwellen-Filter mit einschichtigen, uniplanar realisierten Schaltungskomponenten zu kombinieren.

Der Erfindung liegt die Aufgabe zugrunde, einen Analog-Digital-Wandler für ein Signal im Gigahertz-Bereich, einen Millimeterwellen-Empfänger und einen Bandpaßfilter für Millimeterwellen anzugeben, die es ermöglichen, ein Signal im Gigahertz-Bereich möglichst kostengünstig und störungsarm zu verarbeiten und ohne Zwischenschaltung zusätzlichen Mischstufen unmittelbar digital zu verarbeiten, zu verstärken und darzustellen.
Gelöst wird diese Aufgabe durch einen Analog-Digital-Wandler mit den Merkmalen des Anspruchs 1, einen Millimeterwellen-Empfänger mit den Merkmalen des Anspruchs 9 sowie einen Bandpaßfilter für Millimeterwellen mit den Merkmalen des Anspruchs 10.

Vorteilhafte Weiterbildungen ergeben sich aus den Unteransprüchen.

Der erfindungsgemäße Analog-Digital-Wandler für ein Signal im Gigahertz-Bereich oder im vielfachen Gigahertz-Bereich zeigt einen Signaleingang, dem ein analoges Signal von einer zugeordneten Antenne zugeführt wird, einen dreidimensionalen Filter, dem das Eingangssignal zugeführt ist und der als dreidimensionale Ausnehmung in einem integrierten Schaltkreis realisiert ist. Durch die Gestaltung des dreidimensionalen Filters, insbesondere durch dessen Abmessungen und dessen Formgebung der Ausnehmung sowie der Ausbildung der Singalzuführung und der Signalableitung wird die Mittenfrequenz f0 des Filters, die Bandbreite B und die Güte des Filters festgelegt. Erfindungsgemäß zeigt der Analog-Digital-Wandler eine Sample and Holdstufe, die als zentrales Element einen sehr schnell schaltenden mit einer Taktfrequenz f getakteten Schalter aufweist, sowie einen Komparator zur Erzeugung des digitalisierten Signals. Das durch den Komparator erzeugte digitalisierte Signal wird dem Signalausgang des Analog-Digital-Wandlers zugeführt.

Dabei wird die Abtastfrequenz, die der Taktfrequenz entspricht, so gewählt, daß sie größer als die doppelte gewünschte Bandbreite des digitalisierten Signals, welche der Bandbreite B des dreidimensionalen Filters entspricht, gewählt ist. Dadurch gelingt es, das Nyquist-Abtastkriterium für eine bandbegrenzte Überabtastung bezogen auf die Signalbandbreite zu erfüllen. Erfindungsgemäß gelingt es die Abtastfrequenz gegenüber dem unmittelbaren Abtasten der Trägerfrequenz f0 im Gigahertz-Bereich abzusenken.

Durch die erfindungsgemäße Wahl des Filters, nicht als planarer Filter, sondern als dreidimensionaler Filter, der entsprechend einem Hohlraumresonator wirkt, gelingt es, eine ausgesprochen hohe Güte des Filters zu erreichen, was für das unmittelbare Digitalisieren des Nutzsignales von besonderer Bedeutung ist. Durch die erfindungsgemäße Kombination des dreidimensionalen Filters mit einer Sample and Holdstufe mit einem schnellen Schalter, der vorzugsweise als Silizium-Germanium-Heterobipolar-Transistor (SiGeHBT) realisiert ist, oder auch durch getaktete SIMMWIC-Schottkyoder -PIN-Dioden realisiert werden kann, wird es möglich, eine hohe Auflösung des Analog-Digital-Wandlers auch für sehr hohe Frequenzen zu erreichen. Dadurch wird es erfindungsgemäß möglich, das Signal über einen großen Dynamikbereich zu digitalisieren. SIMMWIC-Schottky- oder -PIN-Dioden sind als solche aus J.-F. Luy, P. Russer "Silicon Based mm-Wave Devices", 1994, Springer Verlag, bekannt.

Vorzugsweise werden der dreidimensionale Filter und die Sample and Holdstufe sowie insbesondere der Komparator in einer einzigen integrierten Schaltung realisiert, so daß die einzelnen Komponenten des Analog-Digital-Wandlers dieselben charakteristischen Eigenschaften insbesondere im Hinblick auf die Temperaturstabilität, das Rauschverhalten und ähnliches zeigen, so daß eine Kompensation dieser Effekte, welche zu einer verringerten Qualität bei der Analog-Digital-Wandlung führen und gemeinsam durch ein Gegenmittel angegangen werden kann. Weiterhin ermöglicht dieses gemeinsame Realisieren der Komponenten in einem integrierten Schaltkreis eine erhebliche Kostenreduktion, da nicht verschiedene unterschiedliche Fertigungsprozesse verwendet werden müssen und aufeinander abzustimmen sind. Damit gelingt es, die Kosten für einen derartigen Analog-Digital-Wandler erheblich zu reduzieren. Weiterhin ist es durch den erfindungsgemäßen Analog-Digital-Wandler möglich, ohne Verwendung zusätzlicher Mischerkomponenten Signale im Gigahertz-Bereich oder darüber unmittelbar zu digitalisieren und dadurch weitere Kosten zu senken. Erfindungsgemäß weist der Analog-Digital-Wandler sehr wenige aktive Komponenten, Bauteile auf, wodurch er sehr verlustarm, störungsarm und schnell arbeiten kann.

Nach einer bevorzugten Ausführungsform der Erfindung wird ein Differenzverstärker zwischen der Sample and Holdstufe und dem Komparator angeordnet. Diesem wird zum einen das Nutzsignal von der Sample and Holdstufe zugeführt und zum anderen ein rückgekoppeltes Signal, das nach dem Komparator abgegriffen wird und das nach einer Anpassung, insbesondere durch eine Digital-Analog-Wandlung, zugeführt. Durch diese Anordnung gelingt es, eine bandselektive Rauschformung des Nutzsignals vorzunehmen und dadurch die Qualität des Signals merklich zu erhöhen.

Nach einer besonders bevorzugten Ausführungsform der Erfindung ist der dreidimensionale Filter als quaderförmige Ausnehmung ausgebildet, welche vorzugsweise induktiv an die Signalzuführung und Signalableitung angekoppelt ist. Durch die induktive Ankopplung ist es erfindungsgemäß möglich, durch entsprechende Wahl der lateralen Ausdehnung der Ausnehmung weitgehend unabhängig von der Tiefe der Ausnehmung eine gewünschte Mittenfrequenz f0 im Gigahertz-Bereich sowie eine gewünschte Bandbreite B festzulegen. Soll beispielsweise ein derartiger dreidimensionaler Filter für eine Frequenz von 30 GHz realisiert werden, so weist die Ausnehmung typisch eine Länge in der Größenordnung von etwa 0,5 cm auf.

Durch die Wahl der weiteren Abmessungen der Ausnehmung sind die anderen Filtereigenschaften festgelegt, insbesondere die Güte, die in einem Bezug zu dem Volumen der Ausnehmung steht.

Nach einer weiteren bevorzugten Ausbildungsform der Erfindung ist der dreidimensionale Filter als mikromechanischer Filter ausgebildet, durch dessen mikromechanische Eigenschaften die Filtereigenschaften umschaltbar oder veränderbar ausgebildet sind. Vorzugsweise zeigt der dreidimensionale mikromechanische Filter eine durch einen mikromechanischen Antrieb verschiebliche Wand innerhalb der Ausnehmung, durch die die Resonanzeigenschaften der Ausnehmung verändert werden kann und dadurch die Mittenfrequenz, die Bandbreite oder die Güte des Filters verändert werden kann. Dadurch wird es möglich, ein und denselben Filter für verschiedene Frequenzen im Gigahertz-Bereich, beispielsweise für eine Mittenfrequenz von 30 GHz oder 31 GHz oder 32 GHz anpaßbar zu machen. Die Realisierung der mikromechanischen Eigenschaften erfolgt in einem Fertigungsprozeß zusammen mit einer oder mit mehreren oder mit allen anderen Komponenten des Analog-Digital-Wandlers.

Eine andere Ausbildung der Erfindung betrifft einen digitalen Millimeterwellen-Empfänger, der einen erfindungsgemäßen Analog-Digital-Wandler für ein Signal im Gigahertz-Bereich aufweist, dem über den Eingang des Millimeterwellen-Empfängers ein analoges Antennensignal zugeführt wird und dessen Ausgangssignal einer digitalen Signalaufbereitungseinheit zugeführt wird, die das digitale Nutzsignal, beispielsweise das digitale Audiosignal in seinem Frequenzverlauf durch Equalizing verändert bzw. durch entsprechende Delay-Lines zeitlich gliedert oder auch durch Echo-Effekte verändert. Dieses durch die Signalaufbereitungseinheit veränderte digitale Signal wird nach einer fakultativen Verstärkung einem Signalausgang zugeführt, über den das durch den digitalen Millimeterwellen-Empfänger empfangene, digitalisierte und aufbereitete Signal, beispielsweise als Audiosignal unmittelbar an die Lautsprecher zur Wiedergabe weitergegeben werden kann. Dieser Millimeterwellen-Empfänger erweist sich als sehr kompakt und von sehr geringen Kosten, da er auf unnötige Mischstufen verzichten kann und das Millimeterwellensignal unmittelbar durch geeignete Abtastung in Verbindung mit dem dreidimensionalen Filter in den gewünschten Bereich des Nutzsignals überträgt. Erfindungsgemäß ist es möglich, diesen Millimeterwellen-Empfänger auf einer einzigen integrierten Schaltung zu realisieren, wodurch eine Anordnung des erfindungsgemäßen digitalen Millimeterwellen-Empfängers am Ort der Antenne, beispielsweise am oder im Antennenfuß, möglich ist. Dadurch können eine Vielzahl solcher Antennenempfängerkombinationen über ein Fahrzeug verteilt untergebracht werden, was die Empfangslage als Diversity-Empfangssystem erheblich verbessert.

Eine andere Ausbildung der Erfindung zeigt einen Bandpaßfilter für Millimeterwellen, der als dreidimensionales Filter mit einer Ausnehmung in der integrierten Schaltung ausgebildet ist. Die Abmessungen der Ausnehmung sowie die Art der Ankopplung der Signalzuführung der Signalableitung des Filters legen die Filtereigenschaften, insbesondere Bandbreite B und Mittenfrequenz f0 und die Güte fest. Der erfindungsgemäße Bandpaßfilter ist als mikromechanischer Filter ausgebildet, wobei durch den mikromechanischen Antrieb die Eigenschaften des Filters, insbesondere die Bandbreite B, die Mittenfrequenz f0 oder die Güte veränderlich ausgebildet sind, was vorzugsweise durch eine mikromechanisch getriebene Verschiebung einer in die Ausnehmung hineinragenden Wand erfolgt. Dabei wird die Wand durch den mikromechanischen Antrieb so verschoben, daß die für die Filterung wirksame Ausnehmung vergrößert oder verkleinert wird und dadurch die Filtereigenschaften dementsprechend verändert werden.

Als besonders vorteilhaft hat sich erwiesen, die Ausnehmung mit der Signalzuführung und mit der Signalableitung induktiv zu koppeln, wodurch im wesentlichen die laterale Ausdehnung der Ausnehmung die charakteristische Größe für die Mittenfrequenz darstellt. Durch diese besonders geeignet Form der Ankopplung wird es möglich, daß die erforderliche Tiefe der Ausnehmung gering insbesondere in der Größenordnung der verwendeten Stärke der integrierten Schaltkreise gewählt werden kann und dadurch einer breiten kostengünstigen Realisierung zugeführt werden kann, ohne daß die erfindungsgemäß notwendigen Filtereigenschaften verloren gehen. Durch die induktive Ankopplung und die ausgeprägte laterale Ausdehnung der Ausnehmung des dreidimensionalen Filters werden bei hoher Güte des Filters hohe Mittenfrequenzen f0 im Gigahertz-Bereich ermöglicht. Dabei werden die erforderlichen Bandbreiten B entsprechend dem der gewünschten Bandbreite des Nutzsignals realisierbar. Durch diese Ausbildung des dreidimensionalen Filters mit induktiver Ankopplung ist es möglich, daß mittels gängiger Chipfertigungstechniken derartige dreidimensionale Filter kostengünstig realisiert werden können. Im Rahmen des Fertigungsprozeßes läßt sich erfindungsgemäß auch eine zugeordnete Sample and Holdstufe sowie nachgeordnete Komponenten des Analog-Digital-Wandlers sowie eines digitalen Millimeterwellen-Empfängers realisieren.

Die Erfindung wird nachfolgend unter Bezugnahme auf die Zeichnung erläutert.

Es zeigen:
- Figur 1: einen beispielhaften erfindungsgemäßen Millimeterwellen-Rundfunkempfänger,
- Figur 2: einen beispielhaften erfindungsgemäßen Aufbau eines Bandpaßfilters für Millimeterwellen und
- Figur 3: eine beispielhaften Frequenzcharakteristik eines erfindungsgemäßen Bandpaßfilters.

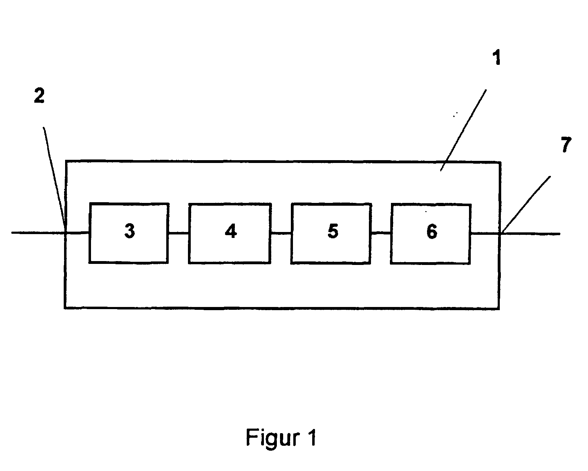

In Figur 1 ist ein Millimeterwellen-Rundfunkempfänger 1 dargestellt, diesem wird an dem Signaleingang 2 ein Antennensignal im Gigahertz-Bereich zugeführt. An den Signaleingang 2 schließt sich ein dreidimensionale Filter 3 an, der in seiner Mittenfrequenz f0 und in seiner Bandbreite B so gewählt ist, daß es das Abtasttheorem von Nyquist im Hinblick auf eine bandbegrenzte Abtastung bzw. Überabtastung eines Nutzsignals mit vorgegebener Bandbreite B erfüllt. Das bandbegrenzte analoge Signal wird einer Sample and Holdstufe 4 zugeführt, die einen sehr schnellen Schalter aufweist, der mit einer Taktfrequenz f getaktet ist. Die Taktfrequenz f ist dabei so gewählt, daß das Nyquist Theorem für bandbegrenztes Abtasten eines Nutzsignals erfüllt ist. Dabei wird von der gewünschten Bandbreite B des Nutzsignals ausgegangen und die Abtastfrequenz f entsprechend gewählt. Das bandbegrenzte abgetastete Signal wird anschließend einem Komparator 5 zugeführt, mit dessen Hilfe ein digitalisiertes Signal gebildet wird. Anschließend wird das digitalisierte Signal einer Signalaufbereitungseinheit 6 zugeführt, die eine Equalizierung, eine Delay-Line, eine Echo-Line oder ähnliches beinhaltet. Anschließend wird das aufbereite digitalisierte Signal, das ggf. ergänzend einer Signalverstärkungseinheit zugeführt wurde, über den Signalausgang 7 an eine Wiederabgabeinheit, beispielsweise in Form eines Displays oder Lautsprechers, weitergeleitet.

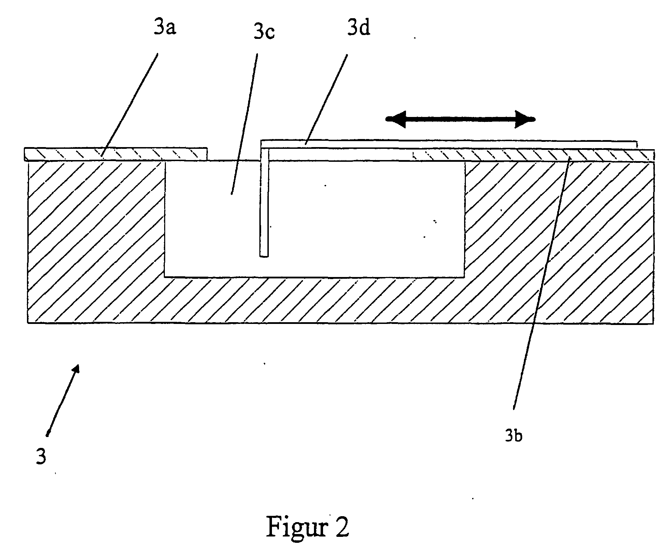

In Figur 2 ist ein Aufbau für einen beispielhaften dreidimensionalen Filter 3 dargestellt, welcher mit Hilfe eines mikromechanischen Antriebs in seinen Filtereigenschaften veränderlich ausgebildet ist. Der dreidimensionale Bandpaßfilter 3 zeigt eine Ausnehmung 3c, die in einer integrierten Schaltung, die im wesentlichen als planare Schaltung ausgebildet ist, angeordnet ist. Die Ausnehmung 3c hat eine ausgeprägte laterale Ausdehnung und eine nicht unerhebliche Tiefe. Das Volumen dieser Ausnehmung 3c des dreidimensionalen Filters 3 bestimmt im wesentlichen dessen Güte. Die Ausnehmung 3c ist mit einer Signalzuführung 3a und einer Signalableitung 3b induktiv gekoppelt. Die Signalzuführung 3a und die Signalableitung 3b ragen über den seitlichen Rand der Ausnehmung 3c über und ermöglichen dadurch ein Einkoppeln des Signals im Gigahertz-Bereich. Wieterhin zeigt der dreidimensionale Filter eine verschiebliche Wand 3d, die mikromechanisch getrieben in der Ausnehmung 3c verschieblich angeordnet ist. Die Verschieblichkeit ist in Figur 2 durch den Doppelpfeil angedeutet. Durch die Verschiebung der Wand 3d gelingt es, die für die Filtereigenschaften relevante, wirksame Ausnehmung 3c des Filters 3 zu verändern und dadurch insbesondere die Filtereigenschaften, wie Mittenfrequenz f0, Bandbreite B und Güte zu verändern.

Damit gelingt es, einen umschaltbaren oder veränderlichen Filter zu schaffen, mittels dem mit ein und derselben nachgeschalteten Sample and Holdstufe sowie der Komparatoranordnung unterschiedliche Rundfunksignale, beispielsweise von 5 GHz, 10 GHz, 30 GHz, 31 GHz oder 32 GHz, zu digitalisiert bzw. im Rahmen eines erfindungsgemäßen Rundfunkempfängers empfangen, verstärkt und zur Anzeige oder Wiedergabe gebracht werden können.

Der dreidimensionale Filter 3 gemäß der Figur 2 einschließlich dem mikromechanischen Antrieb wird gemeinsam mit der integrierten Schaltung in einem Herstellungsprozeß gefertigt. Demzufolge sind keine zusätzlichen Fertigungsprozesse erforderlich. Mithin ergibt sich eine sehr kostengünstige Herstellung des erfindungsgemäßen Filters, des erfindungsgemäßen Analog-Digital-Wandlers sowie des erfindungsgemäßen Millimeterwellen-Rundfunkempfängers.

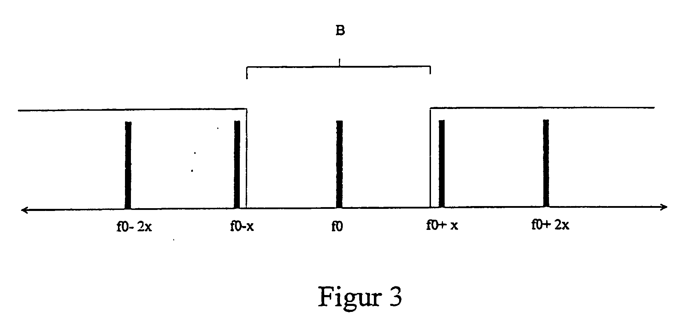

In Figur 3 ist dargestellt, wie durch den erfindungsgemäßen dreidimensionalen Filter 3 ein bestimmtes Frequenzband aus einer Vielzahl von benachbarten Frequenzen im Gigahertz-Bereich selektiert wird. Es ist hier die Trägerfrequenz f0 dargestellt, der verschiedene Nachbarfrequenzen nebengeordnet sind. Der Kanalabstand X der Nachbarfrequenzen ist konstant. Durch den erfindungsgemäßen dreidimensionalen Filter mit Bandpaßcharakteristik ist sichergestellt, daß die Nachbarfrequenzen zu der gewünschten Trägerfrequenz f0 unterdrückt werden, indem die Mittenfrequenz des dreidimensionalen Filters gleich f0 gewählt ist und die Bandbreite B so gewählt ist, daß die unmittelbaren Nachbarfrequenzen nicht erfaßt sind. Durch die Wahl der Abmessungen und die Art der Ankopplung des dreidimensionalen Filters 3 werden die Filtereigenschaften festgelegt.

### Bezugszeichenliste

- 1: Millimeterwellen-Empfänger
- 2: Signaleingang
- 3: Dreidimensionaler Filter
- 4: Sample and Holdstufe
- 5: Komparator
- 6: Signalaufbereitungseinheit
- 7: Signalausgang
- 3a: Signalzuführung
- 3b: Signalableitung
- 3c: Ausnehmung
- 3d: verschiebliche Wand

## Patentansprüche

1. Millimeterwellenfilter,
welches als dreidimensionales Filter (3) mit einer Ausnehmung (3c) ausgebildet ist, deren Abmessungen die Filtereigenschaften festlegen,
und bei welchem die Ausnehmung (3c) mit einer Signalzuführung (3a) und einer Signalableitung (3b) verbunden ist,
**dadurch gekennzeichnet,**
**dass** das Filter uniplanar ausgeführt ist, wobei die Ankopplung der Signalzuführung (3a) und der Signalableitung (3b) an die Ausnehmung (3c) so ausgeführt ist, dass die Signaleinkopplung induktiv erfolgt.

2. Millimeterwellenfilter nach Anspruch 1, **dadurch gekennzeichnet, dass** das dreidimensionale Filter (3) als mikromechanisches Filter ausgebildet ist.

3. Millimeterwellenfilter nach Anspruch 2, **dadurch gekennzeichnet, dass** mittels der mikromechanischen Eigenschaften des dreidimensionalen Filters (3) dessen Filtereigenschaften, insbesondere Bandbreite und/oder Mittenfrequenz veränderlich sind.

4. Millimeterwellenfilter nach einem der Ansprüche 2 oder 3, **dadurch gekennzeichnet, dass** eine mikromechanisch realisierte Wand (3d) in der Ausnehmung (3c) des dreidimensionalen Filters (3) vorgesehen ist, die welche verschiebbar ausgebildet ist.

5. Analog-Digital-Wandler (ADC) unter Verwendung eines 3-dimensionalen Millimeterwellenfilters nach einem der Ansprüche 1 bis 4,
dem ein analoges Signal im Gigahertz-Bereich zugeführt wird,
wobei das Signal an einem Signaleingang (2) dem 3-dimensionalen Filter (3) der eine Mittenfrequenz von f_{O} und eine Bandbreite B zeigt, zugeführt wird,
wobei die SampIe and Hold-Stufe (4) der das gefilterte analoge Signal zugeführt wird einen mit einer Taktfrequenz f >= 2B getakteten schnellen Schalter aufweist,
und wobei der Sample and Hold-Stufe (4) ein Komparator (5) zur Erzeugung eines digitalen Signals nachfolgt.

6. Analog-Digital-Wandler (ADC) nach Anspruch 5, **dadurch gekennzeichnet, dass** der dreidimensionale Filter (3), die Sample and Hold-Stufe (4) und der Komparator (5) in einem einzigen integrierten Schaltung sind.

7. Analog-Digital-Wandler (ADC) nach Anspruch 5, **dadurch gekennzeichnet, dass** der Schalter der Sample and Hold-Stufe (4) als SiGeHB-Transistor oder mittels SIMMWIC-Schottky-Dioden oder mittels SIMMWIC-Pin-Dioden ausgebildet ist.

8. Analog-Digital-Wandler (ADC) nach Anspruch 5, **dadurch gekennzeichnet, dass** zwischen der Sample and Hold-Stufe (4) und dem Komparator (5) ein Differenzverstärker zur band-selektiven Rauschformung vorgesehen ist, dem das Nutzsignal von der Sample and Hold-Stufe (4) und ein nach dem Komparator ausgekoppeltes und rückgekoppeltes Signal zugeführt ist.

9. Millimeterwellen-Empfänger unter Verwendung eines Analog-Digital-Wandlers (ADC) nach einem der Ansprüche 5 bis 8, **dadurch gekennzeichnet, dass** der Millimeterwellen-Empfänger über einen Eingang (2) für ein analoges Signal im Gigahertz-Bereich verfügt, welcher mit dem Eingang des ADC verbunden ist,
und dass der Millimeterwellen-Empfänger über eine Einheit zur signalaufbereitung (6) zur Verarbeitung des durch den ADC gelieferten digitalen Signals verfügt.

## Claims

1. Millimetric wave filter, which is in the form of a three-dimensional filter (3) with a recess (3c), whose dimensions define the filter characteristics,
and in which the recess (3c) is connected to a signal input supply (3a) and to a signal output (3b),
**characterized**
**in that** the filter is uniplanar, with the coupling of the signal input supply (3a) and of the signal output (3b) to the recess (3c) being designed such that signal injection takes place inductively.

2. Millimetric wave filter according to Claim 1, **characterized in that** the three-dimensional filter (3) is in the form of a micromechanical filter.

3. Millimetric wave filter according to Claim 2, **characterized in that** the micromechanical characteristics of three-dimensional filter (3) allow its filter characteristics, in particular its bandwidth and/or mid-frequency, to be varied.

4. Millimetric wave filter according to one of Claims 2 or 3, **characterized in that** a wall (3), which is in micromechanical form, is provided in the recess (3c) of the three-dimensional filter (3) and is designed such that it can be moved.

5. Analogue/digital converter (ADC) using a 3-dimensional millimetric wave filter according to one of Claims 1 to 4,
to which an analogue signal in the Gigahertz band is supplied,
with the signal being supplied at a signal input (2) to the 3-dimensional filter (3), which has a mid-frequency of f₀ and a bandwidth B,
with the sample and hold stage (4) to which the filtered analogue signal is supplied having a high-speed switch which is clocked at a clock frequency f>= 2B,
and with the sample and hold stage (4) being followed by a comparator (5) for producing a digital signal.

6. Analogue/digital converter (ADC) according to Claim 5, **characterized in that** the three-dimensional filter (3), the sample and hold stage (4) and the comparator (5) are in a single integrated circuit.

7. Analogue/digital converter (ADC) according to Claim 5, **characterized in that** the switch in the sample and hold stage (4) is in the form of an SiGeHB transistor, or is formed by means of SIMMWIC Schottky diodes, or by means of SIMMWIC pin diodes.

8. Analogue/digital converter (ADC) according to Claim 5, **characterized in that** a differential amplifier is provided between the sample and hold stage (4) and the comparator (5), for band-selective noise forming, to which differential amplifier the useful signal from the sample and hold stage (4) and a signal which is emitted and is fed back downstream of the comparator are supplied.

9. Millimetric wave receiver using an analogue/digital converter (ADC) according to one of Claims 5 to 8, **characterized in that** the millimetric wave receiver has an input (2) for an analogue signal in the Gigahertz band, which input (2) is connected to the input of the ADC,
and **in that** the millimetric wave receiver has a unit for signal preprocessing (6), in order to process the digital signal which is supplied by the ADC.

## Revendications

1. Filtre pour ondes millimétriques,
configuré comme filtre tridimensionnel (3) avec un évidement (3c) dont les dimensions définissent les propriétés de filtrage,
et dans lequel l'évidement (3c) est relié à une amenée de signal (3a) et une sortie de signal (3b),
**caractérisé en ce que**
le filtre est réalisé en un seul plan, le couplage de l'amenée de signal (3a) et de la sortie de signal (3b) avec l'évidement (3c) étant configuré de telle sorte que le couplage des signaux s'effectue par induction.

2. Filtre pour ondes millimétriques selon la revendication 1, **caractérisé en ce que** le filtre tridimensionnel (3) est configuré comme filtre micromécanique.

3. Filtre pour ondes millimétriques selon la revendication 2, **caractérisé en ce que** les propriétés du filtre tridimensionnel (3), en particulier sa largeur de bande et/ou sa fréquence centrale, peuvent être modifiées au moyen de ses propriétés micromécaniques.

4. Filtre pour ondes millimétriques selon l'une des revendications 2 ou 3, **caractérisé en ce qu'**une paroi (3d) réalisée par micromécanique est prévue dans l'évidement (3c) du filtre tridimensionnel (3) qui est configuré de manière à pouvoir coulisser.

5. Convertisseur analogique-numérique (ADC) utilisant un filtre tridimensionnel pour ondes millimétriques selon l'une des revendications 1 à 4,
sur lequel est appliqué un signal analogique dans la plage des gigahertz,
le signal étant appliqué sur une entrée de signal (2) du filtre tridimensionnel (3) qui présente une fréquence centrale de f₀ et une largeur de bande B,
l'étage d'échantillonnage et de maintien (4) sur lequel le signal analogique filtré est appliqué présentant un commutateur rapide cadencé à une fréquence d'horloge f >= 2B,
et l'étage d'échantillonnage et de maintien (4) étant suivi par un comparateur (5) pour la création d'un signal numérique.

6. Convertisseur analogique-numérique (ADC) selon la revendication 5, **caractérisé en ce que** le filtre tridimensionnel (3), l'étage d'échantillonnage et de maintien (4) et le comparateur (5) sont disposés dans un circuit intégré unique.

7. Convertisseur analogique-numérique (ADC) selon la revendication 5, **caractérisé en ce que** le commutateur de l'étage d'échantillonnage et de maintien (4) est configuré comme transistor SiGeHB ou au moyen de diodes SIMMWIC-Schottky ou au moyen de diodes SIMMWIC-Pin.

8. Convertisseur analogique-numérique (ADC) selon la revendication 5, **caractérisé en ce qu'**entre l'étage d'échantillonnage et de maintien (4) et le comparateur (5) est prévu un amplificateur différentiel pour la formation d'un bruit sélectif en fonction de la bande sur lequel sont appliqués le signal utile de l'étage d'échantillonnage et de maintien (4) et un signal extrait et rétro-couplé après le comparateur.

9. Récepteur d'ondes millimétriques utilisant un convertisseur analogique-numérique (ADC) selon l'une des revendications 5 à 8, **caractérisé en ce que** le récepteur d'ondes millimétriques dispose d'une entrée (2) pour un signal analogique dans la plage des gigahertz qui est reliée à l'entrée de l'ADC, et **en ce que** le récepteur d'ondes millimétriques dispose d'une unité (6) de préparation du signal pour le traitement du signal numérique délivré par l'ADC.
